(19) Europäisches Patentamt
European Patent Office
Office européen des brevets

(11) EP 4 541 857 A1

# (12) EUROPEAN PATENT APPLICATION

published in accordance with Art. 153(4) EPC

(43) Date of publication:
**23.04.2025 Bulletin 2025/17**

(21) Application number: **23823996.6**

(22) Date of filing: **16.06.2023**

(51) International Patent Classification (IPC):
***C08L 83/07*** *(2006.01)* ***C08K 3/013*** *(2018.01)*
***C08L 83/05*** *(2006.01)* ***C08L 83/06*** *(2006.01)*
***H01L 23/373*** *(2006.01)*

(52) Cooperative Patent Classification (CPC):
**C08K 3/013; C08L 83/04; C08L 83/06; H01L 23/373**

(86) International application number:
**PCT/JP2023/022389**

(87) International publication number:
**WO 2023/243706 (21.12.2023 Gazette 2023/51)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **17.06.2022 JP 2022098431**

(71) Applicant: **SEKISUI CHEMICAL CO., LTD.**
**Osaka-shi**
**Osaka**
**530-8565 (JP)**

(72) Inventors:
- **INUI, Osamu**
  **Mishima-gun, Osaka 618-0021 (JP)**
- **NISHIZAWA, Hidehito**
  **Mishima-gun, Osaka 618-0021 (JP)**

(74) Representative: **Ter Meer Steinmeister & Partner**
**Patentanwälte mbB**
**Nymphenburger Straße 4**
**80335 München (DE)**

## (54) SILICONE COMPOSITION, HEAT DISSIPATING MEMBER, AND ELECTRONIC APPARATUS

(57) A silicone composition comprising: (a) an organopolysiloxane having at least two alkenyl groups in one molecule; (b1) an organohydrogenpolysiloxane having hydrogen atoms directly bonded to silicon atoms at both two molecular chain ends and molecular-chain side chains; (b2) an organohydrogenpolysiloxane having hydrogen atoms directly bonded to silicon atoms only at two molecular chain ends; (c) a thermally conductive filler;(d) a curing catalyst; and (e) an organopolysiloxane having no addition reactive group; wherein a ratio (H/Vi) of the number of hydrogen atoms directly bonded to silicon atoms to the number of alkenyl groups is in the range of 0.5 or more and 1.5 or less.

EP 4 541 857 A1

## Description

### Technical Field

The present invention relates to a silicone composition, a heat-dissipating member formed from the composition, and an electronic component comprising the heat-dissipating member.

### Background Art

In electronic devices, integrated electronic components may generate heat, which causes failures. Therefore, heat-dissipating members have been conventionally widely used to dissipate the heat generated from the electronic components to the outside of the device. The heat-dissipating member is disposed between a heat-generating element such as an electronic component and a heat-dissipating element such as a housing or a heat sink. The heat-dissipating member is often formed by curing a silicone composition containing a silicone resin and a thermally conductive filler, as disclosed, for example, in PTLs 1 to 3.

In recent years, with the miniaturization and higher performance of electric devices, the heat-dissipating members are required to be increased in thermal conductivity in order to more efficiently dissipate the heat generated by driving the electric devices. In order to increase the thermal conductivity, the filling ratio of a thermally conductive filler is considered to be increased.

### Citation List

### Patent Literature

PTL1: JP 6149831 B
PTL2: JP 6079792 B
PTL3: JP 6388072 B

### Summary of Invention

### Technical Problem

However, if the filling rate of the thermally conductive filler is increased, the heat-dissipating member may be impaired in flexibility or be difficult to stretch, so that when an external impact is applied to the electronic device, the cured product may not be able to fully absorb the impact, which results in damage to the electronic component. In addition, there is the problem that the reliability when used for a long period of time, so-called long-term reliability, is insufficient. Specifically, when used for a long period of time under a high-temperature environment, the hardness increases, which may lead to the problems that the heat-dissipating member is detached from the heat-generating element or the like due to vibration or impact, resulting in a deterioration in thermal resistance value.

Various types of research have been made to resolve the problems associated with highly filling the thermally conductive fillers in conventional silicone compositions. For example, Patent Literature 1 proposes a silicone composition comprising an organopolysiloxane having an aliphatic unsaturated hydrocarbon group, a silicone resin having a specific structure, a thermally conductive filler, an organohydrogenpolysiloxane having a specific structure, and a platinum group metal catalyst, and the like, each in a specific amount. It describes that the composition has good adhesion even when it comprises the thermally conductive filler in a large amount.

However, it has been difficult for conventional silicone compositions to achieve high flexibility and elongation and excellent long-term reliability while increasing the thermal conductivity.

Therefore, it is an object of the present invention to provide a silicone composition that has high flexibility and elongation and an excellent long-term reliability while increasing the thermal conductivity of a heat-dissipating member produced from the silicone composition.

### Solution to Problem

After diligent research to resolve the above problems, the present inventors have found that the above problems can be resolved by including, in a silicone composition, two types of organohydrogenpolysiloxanes different in the number of SiH in one molecule and in bonding position of each Si-H, and have completed the present invention.

That is, the present invention provides the [1] to [24] as follows:

[1] A silicone composition comprising: (a) an organopolysiloxane having at least two alkenyl groups in one molecule; (b1) an organohydrogenpolysiloxane having hydrogen atoms directly bonded to silicon atoms at both two molecular chain ends and molecular-chain side chain; (b2) an organohydrogenpolysiloxane having hydrogen atoms directly bonded to silicon atoms only at two molecular chain ends; (c) a thermally conductive filler; and (d) a curing catalyst; a ratio (H/Vi) of the number of hydrogen atoms being directly bonded to silicon atoms to the number of alkenyl groups is in the range of 0.5 or more and 1.5 or less.
[2] The silicone composition according to [1], wherein a viscosity at 23°C of the component (a) is 20 mPa·s or more and 100,000 mPa·s or less.
[3] The silicone composition according to [1] or [2], wherein the component (a) comprises alkenyl groups only at two molecular chain ends of a polysiloxane structure.
[4] The silicone composition according to any of [1] to [3], wherein the alkenyl group in the component (a) is a vinyl group.
[5] The silicone composition according to any of [1] to [4], wherein a content of the (c) thermally conductive filler is 1,000 parts by mass or more and 4,000 parts by mass or less relative to 100 parts by mass of the organopolysiloxane in the silicone composition.
[6] The silicone composition according to any of [1] to [5], wherein a content of the (d) curing catalyst is 0.1 ppm by mass or more and 500 ppm by mass or less.
[7] The silicone composition according to any of [1] to [6], further comprising (g) a curing inhibitor.
[8] The silicone composition according to any of [1] to [7], comprising an organosilicon compound having a hydrolyzable silyl group at the molecular chain end.
[9] The silicone composition according to any of [1] to [8], wherein in the component (b1), the molecular-chain side chains have 4 to 15 hydrogen atoms.
[10] The silicone composition according to any of [1] to [9], wherein a ratio (b1/b2) of the number of hydrogen atoms in the component (b1) to the number of hydrogen atoms in the component (b2) is 0.01 to 20.
[11] The silicone composition according to any of [1] to [10], wherein the organohydrogenpolysiloxane in the silicone composition consists of the component (b1) and the component (b2).
[12] The silicone composition according to any of [1] to [11], wherein the (c) thermally conductive filler is at least one selected from the group consisting of an oxide, a nitride, a carbide, a carbon-based material and a metal hydroxide.
[13] The silicone composition according to any of [1] to [12], wherein the (c) thermally conductive filler is at least one selected from the group consisting of alumina, diamond and aluminum nitride.
[14] The silicone composition according to any of [1] to [13], wherein an average particle size of primary particles of the (c) thermally conductive filler is 0.1 μm or more.
[15] The silicone composition according to any of [1] to [14], wherein the (c) thermally conductive filler comprises two or more types of particles different in average particle diameters of primary particles.
[16] The silicone composition according to any of [1] to [15], further comprising (e) an organopolysiloxane having no addition reactive group.
[17] The silicone composition according to [16], comprising, as the component (e), at least one compound selected from the group consisting of a compound represented by the following formula (1) and a compound represented by the following formula (2):

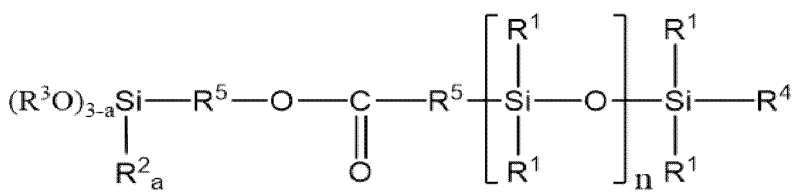

(1)

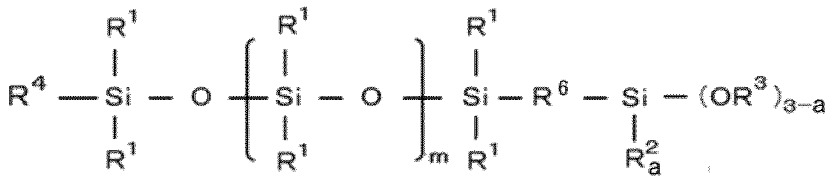

(2)

wherein:

in each of the formulas (1) and (2), each $R^1$ is independently any one of an alkyl group having 1 to 20 carbon atoms, a halogenated alkyl group having 1 to 20 carbon atoms, an aryl group having 6 to 20 carbon atoms and an aralkyl group having 7 to 20 carbon atoms, and the multiple $R^1$s in each formula may be each the same or different; each $R^2$ is independently an alkyl group having 1 to 4 carbon atoms, and when multiple $R^2$s are present in each formula, the multiple $R^2$s may be each the same or different; each $R^3$ is independently any one of an alkyl group having 1 to 4 carbon atoms, an alkoxyalkyl group having 2 to 4 carbon atoms and an acyl group having 2 to 4 carbon atoms, and when multiple $R^3$s are present in each formula, the multiple R3s may be each the same or different; and each $R^4$ is independently an alkyl group having 1 to 8 carbon atoms;
in the formula (1), each $R^5$ is independently a divalent hydrocarbon group having 2 to 20 carbon atoms, and the multiple $R^5$s may be each the same or different;
in the formula (2), $R^6$ is an oxygen atom or a divalent hydrocarbon group having 2 to 20 carbon atoms;
in each of the formulas (1) and (2), a is an integer from 0 to 2;
in the formula (1), n is an integer from 4 to 150; and
in the formula (2), m is an integer from 15 to 315.

[18] The silicone composition according to any of the above [1] to [17], wherein a cured product obtained by curing the silicone composition has a type E hardness of less than 70.
[19] The silicone composition according to any of [1] to [18], wherein a content of the component (a) is 30% by mass or more and 90% by mass or less and a total content of the component (b1) and the component (b2) is 5% by mass or more and 50% by mass or less, relative to a total amount of organopolysiloxane.
[20] The silicone composition according to any of [1] to [19], wherein a viscosity at 23°C of the component (b1) is 20 mPa·s or more and 100,000 mPa·s or less, and a viscosity at 23°C of the component (b2) is 20 mPa·s or more and 100,000 mPa·s or less.
[21] The silicone composition according to any of the above [1] to [20], wherein the (d) curing catalyst is a platinum-based catalyst.
[22] The silicone composition according to any of the above [1] to [21], wherein primary particles of the (c) thermally conductive filler have an average particle diameter of 200 μm or less.
[23] A heat-dissipating member formed from the silicone composition according to any of the above [1] to [22].
[24] An electronic device comprising an electronic component and the heat-dissipating member according to the above [23] disposed on the electronic component.

Advantageous Effect of Invention

By using the silicone composition of the present invention, it is possible to obtain a heat-dissipating member that has a high flexibility and elongation and an excellent long-term reliability while increasing the thermal conductivity of the heat-dissipating member.

Description of Embodiments

[Silicone composition]

The silicone composition of the present invention will be described in detail below.
The silicone composition of the present invention comprises the following components (a), (b1), (b2), (c) and (d).

<Component (a)>

The component (a) is an organopolysiloxane having at least two alkenyl groups in one molecule. By including the component (a), the silicone composition is subjected to addition reaction with an organohydrogenpolysiloxane (the component (b1), (b2)) described below, and the silicone composition can be cured.
The organopolysiloxane to be used as the component (a) may be linear or branched or may be a mixture of linear and branched, but it is preferably linear.
The alkenyl group in the component (a) may be included at either the molecular chain end or the molecular-chain side chain of the polysiloxane structure of the component (a), or may be included at both the molecular-chain side chain and the molecular chain end, but it is preferably included at least at the molecular chain end, more preferably at the two molecular chain ends, and even more preferably only at the two molecular chain ends. By including the alkenyl group only at the two molecular chain ends, the effect of increasing the distance between the crosslinking points, which enhances elongation can be achieved.
Examples of the alkenyl group include, but not particularly limited to, an alkenyl group having 2 to 8 carbon atoms,

such as a vinyl group, an allyl group, a butenyl group, a pentenyl group, a hexenyl group, a heptenyl group or an octenyl group. Of these, a vinyl group is preferred, from the viewpoint of ease of synthesis, reactivity, and the like. In addition, it is preferred that the alkenyl group is an alkenyl group directly bonded to a silicon atom.

The number of alkenyl groups in one molecule of the component (a) is not particularly limited as long as it is 2 or more, but it is, for example, 2 to 8, preferably 2 to 4, and more preferably 2.

Examples of the other group bonded to a silicon atom in addition to the alkenyl group in the organopolysiloxane of the component (a) include a hydrocarbon group optionally having a substituent. Examples of the hydrocarbon group optionally having a substituent include a hydrocarbon group having about 1 to 20 carbon atoms. Specific examples thereof include an alkyl group having 1 to 20 carbon atoms, a halogenated alkyl group having 1 to 20 carbon atoms, an aryl group having 6 to 20 carbon atoms and an aralkyl group having 7 to 20 carbon atoms.

The alkyl group may be linear or branched, or may have a cyclic structure. More specific examples of the hydrocarbon group include a linear alkyl group such as a methyl group, an ethyl group, a propyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group or an eicosyl group; a branched alkyl group such as an isopropyl group, a tertiary butyl group, an isobutyl group, a 2-methylundecyl group or a 1-hexylheptyl group; and a cyclic alkyl group such as a cyclopentyl group, a cyclohexyl group or a cyclododecyl group.

Examples of the halogenated alkyl group include a chloromethyl group, a 3,3,3-trifluoropropyl group and a 3-chloropropyl group. Examples of the aryl group include a phenyl group, a tolyl group and a xylyl group. Example of the aralkyl group include a benzyl group, a phenethyl group and a 2-(2,4,6-trimethylphenyl)propyl group.

Of these, an alkyl group is preferred, and a methyl group is preferred from the viewpoint of ease of synthesis. In addition, preferably 80 mol% or more, more preferably 90 mol% or more, and even more preferably 100% of the other group bonded to a silicon atom is a methyl group. It is preferred that the component (a) comprises no hydrogen atom as the other group bonded to a silicon atom, that is, it comprises no hydrosilyl group.

Specific examples of the component (a) include a compound represented by the following formula (A).

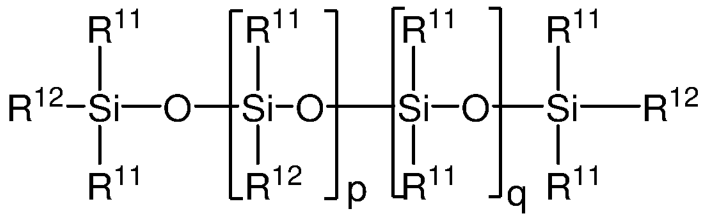

(A)

In the formula (A), each $R^{11}$ is independently a hydrocarbon group optionally having a substituent other than an alkenyl group. Each $R^{12}$ is independently an alkenyl group. Details of the hydrocarbon group optionally having a substituent and the alkenyl group are as described above. $R^{11}$ is preferably an alkyl group and more preferably a methyl group. Preferably 80% or more, more preferably 90% or more and even more preferably 100% of $R^{11}$ is a methyl group. $R^{12}$ is preferably a vinyl group.

In the formula (A), p is the number of repeating units and is, for example, an integer of 0 to 8, preferably 0 to 2 and more preferably 0. q is the number of repeating units and is an integer of 1 or more, but it is preferably such a number of repeating units that the viscosity at 23°C is within the range described below, and it is, for example, about 20 to 1,500.

In the formula (A), the structural unit represented by $-SiR^{11}R^{12}O-$ and the structural unit represented by $-SiR^{11}R^{11}O-$ may be polymerized randomly or in blocks.

The organopolysiloxane of the component (a) may be used alone or in combination of two or more thereof.

The viscosity at 23°C of the component (a) is not particularly limited, but is preferably 20 mPa·s or more and 100,000 mPa·s or less. The viscosity of the component (a) of the above lower limit value or more prevents the crosslink density from being too high in the cured product, making it easier to maintain the flexibility after curing. The viscosity of the component (a) of the above upper limit or less can prevent the silicone composition from being highly viscous. The viscosity of the component (a) within the above range makes the molecular weight of the component (a) appropriate, making it easier to make the reactivity proper. The viscosity at 23°C of the component (a) is more preferably 40 mPa·s or more and 10,000 mPa·s or less, and even more preferably 60 mPa·s or more and 1,000 mPa·s or less.

The viscosity at 23°C of the component (a) can be measured with a Brookfield B-type viscometer. In the Brookfield B-type viscometer, it is preferred that the spindle is properly selected so that the torque is 10 to 80%. The same applies to the viscosity of each of the components (b1) and (b2) described below.

The content of the component (a) may be appropriately selected so that the ratio (H/Vi) described below, and the like can be adjusted within the desired range, and it is not particularly limited, but it is, for example, 30% by mass or more and 90% by mass or less, preferably 40% by mass or more and 85% by mass or less, and more preferably 45% by mass or

more and 80% by mass or less, relative to the total amount of organopolysiloxane in the silicone composition.

<Component (b1), (b2)>

The component (b1) is an organohydrogenpolysiloxane having hydrogen atoms directly bonded to silicon atoms (hereinafter sometimes referred to as "Si-H") at both the two molecular chain ends and the molecular-chain side chain. The component (b2) is an organohydrogenpolysiloxane having hydrogen atoms directly bonded to silicon atoms (Si-H) only at the two molecular chain ends.

By including the component (b2), in addition to the component (b1), in the silicone composition of the present invention, the composition can be cured while achieving an appropriate level of chain extension and while making crosslinking points sparse. Therefore, even when the (c) thermally conductive filler is highly filled, the flexibility after curing can be ensured to ensure a certain degree of stretchability. Even when the product is heated at a high temperature for a long period of time after curing, an increase in hardness can be suppressed, ensuring long-term reliability. That is, by suppressing an increase in hardness even when heated for a long period of time, the cured product of the silicone composition can be suppressed from detaching from a heat-generating element and the like even when exposed to vibration or impact, thereby maintaining a good thermal resistance for a long period of time.

Therefore, by including both the components (b1) and (b2), the silicone composition of the present invention can form a cured product, having excellent flexibility and stretchability, of which the long-term reliability is ensured.

The organohydrogenpolysiloxane to be used as the component (b1) may be linear or branched or may be a mixture of linear and branched, but it is preferably linear. It is preferred that the component (b1) has one Si-H at each of two ends of the linear molecular chain, and Si-H groups at the side chain.

In the component (b1), the number of Si-H present in the side chains in one molecule is, for example, 2 to 30, but preferably 2 to 20, more preferably 4 to 15 and even more preferably 4 to 10. A certain number or less of Si-H in the side chains in the component (b1) can make crosslinking during a curing reaction uniform, preventing deterioration of the thermal resistance value due to an increase in hardness. A certain number or more of Si-H in the side chains does not impair flexibility and stretchability and can prevent a decrease in thermal resistance value also in view of long-term reliability, even when the composition is highly filled.

In the component (b1), examples of the other group bonded to a silicon atom in addition to Si-H include a hydrocarbon group optionally having a substituent. Examples of the hydrocarbon group optionally having a substituent include a hydrocarbon group having about 1 to 20 carbon atoms. Specific examples thereof include an alkyl group having 1 to 20 carbon atoms, a halogenated alkyl group having 1 to 20 carbon atoms, an aryl group having 6 to 20 carbon atoms and an aralkyl group having 7 to 20 carbon atoms. Details of the alkyl group, the halogenated alkyl group, the aryl group and the aralkyl group are as described above for the component (a).

The other group is preferably an alkyl group, and preferably a methyl group from the viewpoint of ease of synthesis and the like. In addition, preferably 80 mol% or more, more preferably 90 mol% or more, and even more preferably 100% of the other group bonded to a silicon atom is a methyl group.

It is preferred that the component (b1) comprises no alkenyl group as the other group bonded to a silicon atom, that is, the component (b1) comprises no alkenyl group.

Specific examples of the component (b1) include a compound represented by the following formula (B1).

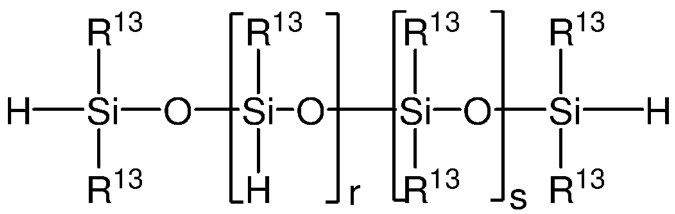

(B1)

In the formula (B1), each $R^{13}$ is independently a hydrocarbon group optionally having a substituent other than an alkenyl group. Details of the hydrocarbon group optionally having a substituent are as described above. $R^{13}$ is preferably an alkyl group, and more preferably a methyl group. In addition, preferably 80% or more, more preferably 90% or more, and even more preferably 100% of $R^{13}$ in the formula (B1) is a methyl group.

In the formula (B 1), the character of r represents the number of repeating units, and it is, for example, 2 to 30, but preferably 2 to 20, more preferably 4 to 15 and even more preferably 4 to 10. The character of s represents the number of repeating units and is an integer of 1 or more, but it is preferably such a number of repeating units that the viscosity at 23°C is within the range described below, and it is, for example, about 20 to 1,500.

In the formula (B1), the structural unit represented by $-SiHR^{13}O-$ and the structural unit represented by $-SiR^{13}R^{13}O-$ may be polymerized randomly or in blocks.

The organohydrogenpolysiloxane of the component (b1) may be used alone or in combination of two or more thereof.

The viscosity at 23°C of the component (b1) is not particularly limited, but is preferably 20 mPa·s or more and 100,000 mPa·s or less. The viscosity within the above range of the component (b1) prevents the crosslink density from being too high, so that the silicone composition can be maintained flexible after curing while preventing it from being highly viscous. In addition, the viscosity within the above range of the component (b1) makes the molecular weight of the component (b1) appropriate, making it easier to make the reactivity proper. The viscosity at 23°C of the component (b1) is more preferably 30 mPa·s or more and 10,000 mPa·s or less, and even more preferably 40 mPa·s or more and 1,000 mPa·s or less.

The component (b2) is an organohydrogenpolysiloxane having hydrogen atoms directly bonded to silicon atoms (hereinafter sometimes referred to as "Si-H") only at the two molecular chain ends. That is, the component (b2) has no Si-H at the molecular-chain side chains.

The organohydrogenpolysiloxane to be used as the component (b2) may be linear or branched or may be a mixture of linear and branched, but it is preferably linear. The component (b2) preferably has one Si-H at each of the two molecular chain ends, that is, it has two Si-H.

Examples of the other group bonded to a silicon atom in addition to Si-H in the component (b2) include a hydrocarbon group optionally having a substituent. Examples of the hydrocarbon group optionally having a substituent include a hydrocarbon group having about 1 to 20 carbon atoms. Specific examples thereof include an alkyl group having 1 to 20 carbon atoms, a halogenated alkyl group having 1 to 20 carbon atoms, an aryl group having 6 to 20 carbon atoms and an aralkyl group having 7 to 20 carbon atoms. Details of the alkyl group, the halogenated alkyl group, the aryl group and the aralkyl group are as described above for the component (a).

The other group is preferably an alkyl group, and preferably a methyl group from the viewpoint of ease of synthesis and the like. In addition, preferably 80 mol% or more, more preferably 90 mol% or more, and even more preferably 100% of the other group bonded to a silicon atom is a methyl group.

It is preferred that the component (b2) comprises no alkenyl group as the other group bonded to a silicon atom, that is, the component (b2) comprises no alkenyl group.

Specific examples of the component (b2) include a compound represented by the following formula (B2).

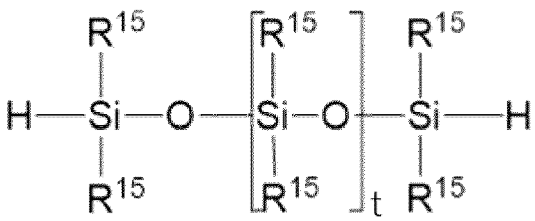

(B2)

In the formula (B2), each $R^{15}$ is independently a hydrocarbon group optionally having a substituent other than an alkenyl group. Details of the hydrocarbon group optionally having a substituent are as described above. $R^{15}$ is preferably an alkyl group, and more preferably a methyl group. In addition, preferably 80 mol% or more, more preferably 90 mol% or more, and even more preferably 100% of $R^{15}$ in the formula (B2) is a methyl group.

In the formula (B2), the character of t represents the number of repeating units and is an integer of 1 or more, but it is preferably such a number of repeating units that the viscosity at 23°C is within the range described below, and it is, for example, about 20 to 1,500.

The organohydrogenpolysiloxane of the component (b2) may be used alone or in combination of two or more thereof.

The viscosity at 23°C of the component (b2) is not particularly limited, but is preferably 20 mPa·s or more and 100,000 mPa·s or less. The viscosity within the above range of the component (b2) prevents the crosslink density from being too high, so that the silicone composition can be maintained flexible after curing while preventing it from being highly viscous. In addition, the viscosity within the above range of the component (b2) makes the molecular weight of the component (b2) appropriate, making it easier to make the reactivity proper. The viscosity at 23°C of the component (b2) is more preferably 30 mPa·s or more and 10,000 mPa·s or less, and even more preferably 40 mPa·s or more and 1,000 mPa·s or less.

The total content of the components (b1) and (b2) may be appropriately selected so that the ratio (H/Vi) described below, and the like can be adjusted within the desired range, and it is not particularly limited, but it is, for example, 5% by mass or more and 50% by mass or less, preferably 10% by mass or more and 45% by mass or less, and more preferably 15% by mass or more and 40% by mass or less, relative to the total amount of organopolysiloxane in the silicone composition.

The ratio (mass ratio) of the component (b1) to the component (b2) is, for example, 0.01 or more and 10 or less,

preferably 0.05 or more and 5 or less, and more preferably 0.08 or more and 3 or less.

<Component (c)>

The component (c) is a thermally conductive filler. By including a thermally conductive filler in the silicone composition, the silicone composition and the cured product (heat-dissipating member) obtained by curing the silicone composition are improved in thermal conductivity.

The (c) thermally conductive filler is not particularly limited, but it is preferably at least one selected from the group consisting of an oxide, a nitride, a carbide, a carbon-based material and a metal hydroxide, and more preferably at least one selected from the group consisting of a metal oxide, a metal nitride, a carbide, a carbon-based material and a metal hydroxide.

Examples of the oxide include a metal oxide such as iron oxide, zinc oxide, alumina, magnesium oxide, titanium oxide, cerium oxide or zirconium oxide, and an oxide other than a metal oxide such as silicon oxide (silica).

Examples of the nitride include a metal nitride such as aluminum nitride, gallium nitride, chromium nitride, tungsten nitride, magnesium nitride, molybdenum nitride or lithium nitride, and a nitride other than a metal nitride such as silicon nitride or boron nitride.

Examples of the carbide include a metal carbide such as aluminum carbide, titanium carbide or tungsten carbide, and a carbide other than a metal carbide such as silicon carbide or boron carbide.

Examples of the carbon-based material include a diamond particle, carbon black, graphite, graphene, fullerene, a carbon nanotube and a carbon nanofiber.

Examples of the metal hydroxide include aluminum hydroxide, calcium hydroxide and magnesium hydroxide.

These thermally conductive fillers may be used alone or in combination of two or more thereof.

Of the above, the thermally conductive filler is preferably at least one selected from the group consisting of alumina, diamond and aluminum nitride, from the viewpoint of easily improving thermal conductivity.

The average particle diameter of primary particles of the (c) thermally conductive filler is not particularly limited, but it is preferably 0.1 μm or more. The average particle diameter of 0.1 μm or more easily increase the thermal conductivity of the silicone composition and easily decrease the viscosity of the silicone composition. The average particle diameter of primary particles of the (c) thermally conductive filler is more preferably 0.2 μm or more and even preferably 0.5 μm or more.

The average particle diameter of primary particles of the (c) thermally conductive filler is preferably 200 μm or less. The average particle diameter of 200 μm or less allows the (c) thermally conductive filler to be properly dispersed in the silicone composition, so that the silicone composition can comprise the (c) thermally conductive filler at a high filling rate. The average particle diameter of primary particles of the (c) thermally conductive filler is more preferably 150 μm or less, and even more preferably 100 μm or less.

The average particle diameter of primary particles can be measured, for example, with a "laser diffraction particle size analyzer" manufactured by Horiba, Ltd., and the particle diameter at 50% cumulative volume (d50) may be taken as an average particle diameter of the primary particles.

The (c) thermally conductive filler preferably comprises two or more types of particles different in average particle diameters of the primary particles. When two or more types of particles different in average particle diameters of primary particles are used, the particles with the smaller average particle diameter get into gaps among the particles with the larger average particle diameter, so that the thermally conductive filler is properly dispersed in an organopolysiloxane while the filling rate of the thermally conductive filler is easily increased. The silicone composition can be determined to have two or more types of particles different in average particle diameters of the primary particles when two or more peaks appear in the particle size distribution of the thermally conductive filler.

When the (c) thermally conductive filler comprises two or more types of particles different in average particle diameters of the primary particles, the specific particle diameter thereof can be selected depending on the type of thermally conductive filler. For example, a thermally conductive filler having an average particle diameter of primary particles of 10 μm or more and 200 μm or less and a thermally conductive filler having an average particle diameter of primary particles of 0.1 μm or more and less than 10 μm may be used in combination.

For example, a thermally conductive filler having an average particle diameter of primary particles of 1 μm or more and 100 μm or less (large particle diameter-thermally conductive filler) and a thermally conductive filler having an average particle diameter of primary particles of 0.1 μm or more and less than 1 μm (small particle diameter-thermally conductive filler) may be used in combination. In this case, the average particle diameter of the primary particles of the large particle diameter-thermally conductive filler is preferably 2 μm or more and 80 μm or less, and more preferably 2 μm or more and 50 μm or less. The average particle diameter of the primary particles of the small particle diameter-thermally conductive filler is preferably 0.1 μm or more and 0.8 μm or less.

The content of the (c) thermally conductive filler in the silicone composition is, for example, 500 parts by mass or more, preferably 800 parts by mass or more, and more preferably 1,000 parts by mass or more, relative to 100 parts by

mass of the organopolysiloxane in the silicone composition. When the content of the (c) thermally conductive filler is 500 parts by mass or more, the thermal conductivity can be enhanced, and when the content is 1,000 parts by mass or more, the thermal conductivity can be sufficiently increased.

The content of the (c) thermally conductive filler is, for example, 4,000 parts by mass or less, preferably 3,000 parts by mass or less, and more preferably 2,500 parts by mass or less, relative to 100 parts by mass of the organopolysiloxane. When the content of the (c) thermally conductive filler is such an upper limit or less, the thermally conductive filler can be properly dispersed in the silicone composition. In addition, the viscosity of the silicone composition can be prevented from being higher than necessary.

The (c) thermally conductive filler can be a surface-treated thermally conductive filler surface-treated with an organosilicon compound having a hydrolyzable silyl group such as an organosilicon compound having a hydrolyzable silyl group at the molecular chain end described later (the component (e-1) or (f)). In particular, the (c) thermally conductive filler is preferably surface-treated with the component (e-1).

The surface-treated thermally conductive filler can be obtained by mixing the (c) thermally conductive filler with the component (e-1) or (f) described below. In addition, it is preferable to use a wet treatment process, a dry treatment process, or the like during mixing, from the viewpoint of easily promoting the surface treatment.

In the wet treatment process, for example, the (c) thermally conductive filler is added to and mixed with a solution in which the component (e-1) or (f) described below is dispersed or dissolved, and then heat-treated to bond or adhere the component (e-1) or (f) to the surface of the thermally conductive filler.

The dry treatment process is a process of surface treatment without using a solution, and specifically, a method in which the (c) thermally conductive filler is mixed with the component (e-1) or (f), stirred with a mixer or the like, and then heat-treated to bond or adhere the component (e-1) or (f) to the surface of the thermally conductive filler. The surface treatment carried out by mixing the (c) thermally conductive filler with the component (e-1) or (f) can also be carried out in the presence of the component (a), (b1) or (b2) described above or the component (e-2) described below.

<Component (d)>

The component (d) is a curing catalyst. By including a curing catalyst in the silicone composition, the curing catalyst can promote the addition reaction between an organopolysiloxane having an alkenyl group (such as a component (a)) and an organohydrogenpolysiloxane (such as a component (b1) and (b2)), thereby properly curing the silicone composition.

Examples of the curing catalyst include a platinum-based catalyst, a palladium-based catalyst and a rhodium-based catalyst. Of these, a platinum-based catalyst is preferred. Examples of the platinum-based catalyst include, but are not limited to, chloroplatinic acid, and a complex compound of chloroplatinic acid with an olefin, a vinylsiloxane or an acetylenic compound.

The content of the curing catalyst in the silicone composition is not particularly limited as long as it is an amount that can promote the addition reaction, but it is preferably 0.1 ppm by mass or more and 500 ppm by mass or less, more preferably 0.5 ppm by mass or more and 200 ppm by mass or less, and even more preferably 1 ppm by mass or more and 100 ppm by mass or less, based on the total amount of the silicone composition.

<<Components (e) and (f)>>

The silicone composition of the present invention preferably comprises an organosilicon compound having no addition reactive group. Specifically, it preferably comprises at least one of an organopolysiloxane having no addition reactive group (a component (e)) and a silane coupling agent having no addition reactive group (a component (f)).

Each of the components (e) and (f) is preferably an organosilicon compound having a hydrolyzable silyl group and particularly preferably an organosilicon compound having a hydrolyzable silyl group at the molecular chain end. Specifically, it is preferably an organopolysiloxane (the component (e-1)) or a silane coupling agent (the component (f)), having a hydrolyzable silyl group at the molecular chain end. By using the organosilicon compound with a hydrolyzable silyl group at the molecular chain end, the filler is made easily dispersed, so that the (c) thermally conductive filler can be highly filled and the thermal conductivity is high.

<Component (e)>

The component (e) is an organopolysiloxane having no addition reactive group as described above. When the silicone composition of the present invention comprises the component (e), the silicone composition of the present invention does not incorporate a certain amount or more of the component into the crosslinked structure in the cured product, making it easier to enhance flexibility. In addition, the viscosity of the silicone composition is made easily decreased, and the handleability thereof is made thereby easily enhanced. The addition reactive group means a functional

group that reacts by addition reaction, and representative examples thereof include an alkenyl group, a methacryloyl group, an acryloyl group, and a hydrosilyl group.

Examples of the component (e) include (e-1) an organopolysiloxane having a hydrolyzable silyl group at the molecular chain end and (e-2) silicone oil. The component (e) may comprise either the component (e-1) or the component (e-2), but preferably comprises at least the component (e-1). When the component (e) comprises the component (e-1), the viscosity of the silicone composition is made further easily decreased. In addition, the filler is made easily dispersed, and as a result, the (c) thermally conductive filler can be highly filled, and the thermal conductivity increases.

The component (e-1) may surface-treat the (c) thermally conductive filler described above, and by surface-treating the (c) thermally conductive filler with the component (e-1), the dispersibility of the filler can be further enhanced.

When the silicone composition comprises the component (e-1), it may further comprise the component (e-2).

The component (e-1) may be linear or branched or may be a mixture of linear and branched, but it is preferably linear. The component (e-1) is preferably an organopolysiloxane having at least one hydrolyzable silyl group at the molecular chain end, more preferably an organopolysiloxane having at least one hydrolyzable silyl group only at one molecular chain end, and even more preferably an organopolysiloxane having three hydrolyzable silyl groups at one molecular chain end. Here, the hydrolyzable silyl group is preferably an alkoxysilyl group and more preferably a methoxysilyl group.

It is presumed that the component (e-1) easily reacts or interacts with functional groups present on the surface of the thermally conductive filler, and the like because of having a hydrolyzable silyl group at the molecular chain end, and also in combination with the presence of a polysiloxane structure, the dispersibility of the filler is enhanced and the viscosity of the silicone composition is made easily decreased. In addition, the dispersibility of the filler is enhanced, so that the (c) thermally conductive filler can be highly filled and the thermal conductivity is thereby easily increased.

Examples of the component (e-1) include a compound represented by the following formula (1) and a compound represented by the following formula (2). Of these, the compound represented by the following formula (1) is preferred. The compound represented by formula (1) can suppress changes in physical properties of the silicone composition at high temperatures and can also enhance the dispersibility. This is presumed to be attributable to the ester structure of the compound represented by formula (1).

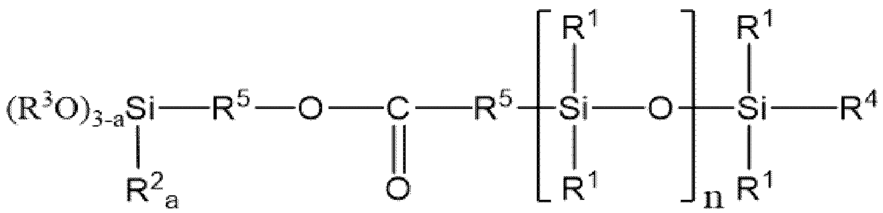

(1)

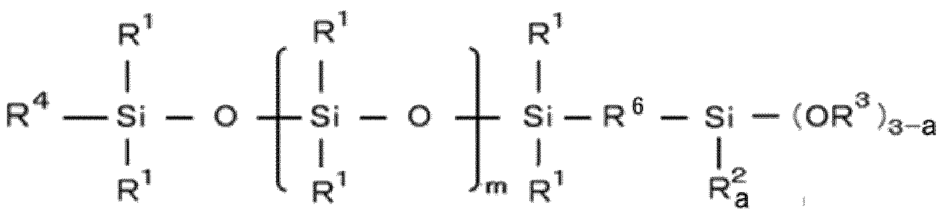

(2)

In each of the formulas (1) and (2), each $R^1$ is independently any one of an alkyl group having 1 to 20 carbon atoms, a halogenated alkyl group having 1 to 20 carbon atoms, an aryl group having 6 to 20 carbon atoms and an aralkyl group having 7 to 20 carbon atoms, and the multiple $R^1$s in each formula may be each the same or different. Each $R^2$ is independently an alkyl group having 1 to 4 carbon atoms, and when multiple $R^2$s are present in each formula, the multiple $R^2$s may be each the same or different. Each $R^3$ is independently any one of an alkyl group having 1 to 4 carbon atoms, an alkoxyalkyl group having 2 to 4 carbon atoms and an acyl group having 2 to 4 carbon atoms, and when multiple $R^3$s are present in each formula, the multiple $R^3$s may be each the same or different. Each $R^4$ is independently an alkyl group having 1 to 8 carbon atoms. In the formula (1), each $R^5$ is independently a divalent hydrocarbon group having 2 to 20 carbon atoms, and the multiple $R^5$s may be each the same or different. In the formula (2), $R^6$ is an oxygen atom or a divalent hydrocarbon group having 2 to 20 carbon atoms. In each of the formulas (1) and (2), the character of a is an integer from 0 to 2. In the formula (1), the character of n is an integer from 4 to 150, and in the formula (2), the character of m is an integer from 15 to 315.

In each of the above formulas (1) and (2), examples of $R^1$ include an alkyl group having 1 to 20 carbon atoms, a halogenated alkyl group having 1 to 20 carbon atoms, an aryl group having 6 to 20 carbon atoms and an aralkyl group having 7 to 20 carbon atoms. The multiple $R^1$'s may be each the same or different.

The alkyl group may be linear or branched, or may have a cyclic structure. More specific examples of the alkyl group include a linear alkyl group such as a methyl group, an ethyl group, a propyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group or an eicosyl group; a branched alkyl group such as an isopropyl group, a tertiary butyl group, an isobutyl group, a 2-methylundecyl group or a 1-hexylheptyl group; and a cyclic alkyl group such as a cyclopentyl group, a cyclohexyl group or a cyclododecyl group.

Examples of the halogenated alkyl group include a chloromethyl group, a 3,3,3-trifluoropropyl group and a 3-chloropropyl group. Examples of the aryl group include a phenyl group, a tolyl group and a xylyl group. Example of the aralkyl group include a benzyl group, a phenethyl group and a 2-(2,4,6-trimethylphenyl)propyl group.

Of these, $R^1$ is preferably an alkyl group having 1 to 20 carbon atoms, more preferably an alkyl group having 1 to 4 carbon atoms, and even more preferably a methyl group.

In each of the above formulas (1) and (2), $R^2$ is an alkyl group having 1 to 4 carbon atoms, and when multiple $R^2$s are present (that is, when the character of a is 2), the multiple $R^2$s may be each the same or different. The alkyl group may be linear or branched. In particular, $R^2$ is preferably an alkyl group having 1 to 2 carbon atoms, and more preferably a methyl group. The character of a is an integer of 0 to 2, and the character of a is preferably 0 or 1 and more preferably 0.

In each of the above formulas (1) and (2), $R^3$ is an alkyl group having 1 to 4 carbon atoms, an alkoxyalkyl group having 2 to 4 carbon atoms or an acyl group having 2 to 4 carbon atoms, and when multiple $R^3$s are present (that is, when the character of a is 0 or 1), the multiple $R^3$s may be each the same or different. The alkyl group, alkoxyalkyl group and acyl group in $R^3$ may be each linear or branched. Of these, $R^3$ is preferably an alkyl group having 1 to 4 carbon atoms, and more preferably a methyl group.

In each of the above formulas (1) and (2), $R^4$ is an alkyl group having 1 to 8 carbon atoms, preferably an alkyl group having 2 to 6 carbon atoms, and more preferably a butyl group.

In the formula (1), $R^5$ is a divalent hydrocarbon group having 1 to 20 carbon atoms, and the multiple $R^5$s may be each the same or different. The divalent hydrocarbon group is preferably an alkylene group, and the alkylene group may be linear or branched. $R^5$ is preferably an alkylene group having 2 to 10 carbon atoms, more preferably an alkylene group having 2 to 8 carbon atoms, even more preferably an alkylene group having 2 to 4 carbon atoms, and still more preferably an alkylene group represented by $-CH_2-CH_2-CH_2-$ or $-CH(CH_3)-CH_2-$.

In the formula (2), $R^6$ is an oxygen atom or a divalent hydrocarbon group having 1 to 20 carbon atoms, and preferably a divalent hydrocarbon group. The divalent hydrocarbon group is preferably an alkylene group, and the alkylene group may be linear or branched. $R^6$ is preferably an alkylene group having 2 to 10 carbon atoms, more preferably an alkylene group having 2 to 8 carbon atoms, and even more preferably an alkylene group having 2 to 4 carbon atoms. Examples thereof include a methylene group, an ethylene group, a propylene group, a butylene group and a methylethylene group. Of these, an ethylene group is preferred.

In the formula (1), the character of n represents the number of repeating units, and it is an integer of 4 to 150, preferably an integer of 5 to 120, and more preferably an integer of 5 to 50.

In the formula (2), the character of m represents the number of repeating units, and it is an integer of 15 to 315, preferably an integer of 18 to 280, and more preferably an integer of 20 to 220.

From the viewpoint of increasing the dispersibility of the thermally conductive filler and obtaining the silicone composition wherein its physical properties less change at high temperature, among the compounds represented by the formulas (1) and (2), the compound represented by the following formula (1-1) or (2-1) is preferred, and the compound represented by the following formula (1-1) is particularly preferred.

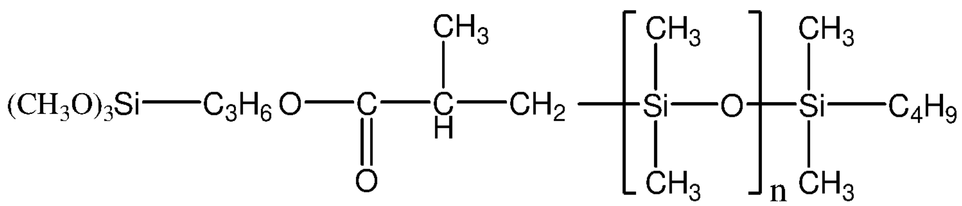

(1-1)

Here, the character of n is as described above.

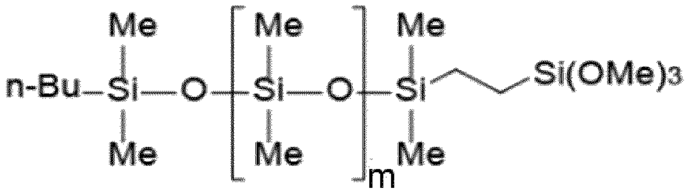

(2-1)

Here, the character of m is as described above.

The component (e-1) may be used alone or in combination of two or more thereof.

Examples of the (e-2) silicone oil include a straight silicone oil such as dimethyl silicone oil or phenylmethyl silicone oil, as well as a non-reactive modified silicone oil wherein a non-reactive organic group is introduced on a main chain with a polysiloxane structure, on a side chain bonded to the main chain, or at the end of the main chain. The non-reactive organic group is an organic group having no addition reactive group. Examples of the non-reactive modified silicone oil include a polyether modified-silicone oil, an aralkyl modified-silicone oil, a fluoroalkyl modified-silicone oil, a long-chain alkyl modified-silicone oil, a higher fatty acid ester modified-silicone oil, a higher fatty acid amide modified-silicone oil, and a phenyl modified-silicone oil. Among the above silicone oils, a straight silicone oil is preferred, and among the straight silicone oils, dimethyl silicone oil is more preferred.

The (e-2) silicone oil may be used alone or in combination of two or more thereof.

The content of the component (e) in the silicone composition is, for example, 1% by mass or more and 50% by mass or less, based on the total amount of the organopolysiloxane in the silicone composition. The content of the component (e) of the above lower limit value or more makes the flexibility of the cured product obtained from the silicone composition to be easily increased and also makes the viscosity of the silicone composition to be easily decreased by the component (e). The content of the component (e) of the above upper limit or less can provide the silicone composition with a certain degree of curability to easily obtain a cured product with the desired physical properties, and bleeding out after curing is also easily prevented. The content of the component (e) in the silicone composition is preferably 2% by mass or more and 45% by mass or less, more preferably 4% by mass or more and 40% by mass or less, and even more preferably 5% by mass or more and 35% by mass or less.

<Component (f)>

The silicone compositions may further comprise (f) a silane coupling agent. The (f) silane coupling agent is an organosilicon compound, other than organopolysiloxane, having a hydrolyzable silyl group at the molecular chain end. As the silane coupling agent, any known agent may be used without any particular limitation, and examples thereof can include dimethyldimethoxysilane, 3-acryloxypropyltrimethoxysilane, 3-methacryloxypropyltrimethoxysilane, vinyltrimethoxysilane, n-decyltrimethoxysilane, 3-isocyanatopropyltriethoxysilane, 3-(2-aminoethyl)aminopropyltrimethoxysilane, 3-mercaptopropyltrimethoxysilane, glycidoxypropyltrimethoxysilane and 3-phenylaminopropyltrimethoxysilane.

The silane coupling agent may be used alone or in combination of two or more thereof.

By including the (f) silane coupling agent in the silicone composition, the filler is easily dispersed, so that the (c) thermally conductive filler can be highly filled and the thermal conductivity is high. The above described (c) thermally conductive filler may have been surface-treated with the component (f), and by surface-treating the (c) thermally conductive filler with the component (f), the dispersibility of the filler can be further enhanced.

The content of the silane coupling agent (f) in the silicone composition is, for example, 0.1 parts by mass or more and 10 parts by mass or less, and preferably 0.5 parts by mass or more and 5 parts by mass or less, relative to 100 parts by mass of the organopolysiloxane in the silicone composition.

In the silicone composition, the (f) silane coupling agent may be used in combination with at least any one of the compounds described above for the component (e), or may be used in combination with the component (e-1).

<(g) Curing inhibitor>

The silicone composition may comprise (g) a curing inhibitor. The (g) curing inhibitor to be used can be any known addition reaction controlling agent that is used for an addition reaction-curing type silicone composition, and is not particularly limited. Examples thereof include an acetylenic compounds such as 1-ethynyl-1-hexanol, 1-ethynyl-2-cyclohexanol, 3-butyn-1-ol, 2-methyl-3-butyn-2-ol, ethynylmethylidenecarbinol or 3,5-dimethyl-1-hexyn-3-ol; a nitrogen compound, an organic phosphorus compound, an oxime compound, an organic chloro compound, and an organic sulfur compound. Of these, an acetylenic compound is preferred.

The content of the (g) curing inhibitor in the silicone composition is not particularly limited, but it is preferably 1 ppm by mass or more and 5,000 ppm by mass or less, more preferably 10 ppm by mass or more and 2,000 ppm by mass or less, and even more preferably 20 ppm by mass or more and 1,000 ppm by mass or less, based on the total amount of the

silicone composition.

In the silicone composition of the present invention, the total content of the components (a) (b1) (b2), and (e) is preferably 2% by mass or more and 40% by mass or less, relative to the total amount of the silicone composition. When the total content of the components (a) (b1) (b2), and (e) is a certain amount or more, these components can properly fulfill their function as binder resins, and the (c) thermally conductive filler can be appropriately held by these components. When the above total content is a certain amount or less, a large amount of the (c) thermally conductive filler can be comprised.

The total content of the components (a) (b1) (b2), and (e) is more preferably 3% by mass or more and 30% by mass or less, even more preferably 3.5% by mass or more and 20% by mass or less, and still more preferably 4% by mass or more and 12% by mass or less, relative to the total amount of the silicone composition.

The organopolysiloxane in the silicone composition of the present invention may consist of the components (a), (b1) and (b2) or the components (a), (b1), (b2) and (e), but may further comprise an organopolysiloxane other than the components (a), (b1), (b2) and (e) as long as the effects of the present invention are not impaired.

Examples of the organopolysiloxane other than the components (a), (b1), (b2) and (e) include an alkenyl group-containing organopolysiloxane other than the component (a), or the organohydrogenpolysiloxane other than the component (b1) and (b2).

Examples of the organohydrogenpolysiloxane other than the components (b1) and (b2) (hereinafter sometimes referred to as a component (b3)) include an organohydrogenpolysiloxane having Si-H only at the one molecular chain end, an organohydrogenpolysiloxane having Si-H at the one molecular chain end and at the molecular-chain side chain, and an organohydrogenpolysiloxane having Si-H only at the molecular-chain side chain. However, it is preferable that the silicone composition comprises no component (b3) or it comprises the component (b3) only in a small amount if any. Such a configuration makes it easier to achieve the effects of the present invention. Specifically, the organohydrogenpolysiloxane in the silicone composition preferably comprises the components (b1) and (b2) in total in a proportion of preferably 70% by mass or more, more preferably 80% by mass or more, even more preferably 90% by mass or more, and most preferably 100% by mass. That is, the organohydrogenpolysiloxane in the silicone composition consists of the components (b1) and (b2).

Examples of the alkenyl group-containing organopolysiloxane other than the component (a) include an organopolysiloxane having one alkenyl group in one molecule. However, it is preferable that the silicone composition of the present invention comprises no organopolysiloxane having an alkenyl group other than the component (a), or even if the silicone composition comprises such an organopolysiloxane, it comprises such an organopolysiloxane in a small amount. Specifically, it is preferable for 70% by mass or more of the alkenyl group-containing organopolysiloxane in the silicone composition to be the component (a), it is more preferable for 80% by mass or more thereof to be the component (a), and it is even more preferable for 90% by mass or more thereof to be the component (a), and it is preferable for 100% by mass thereof to be the component (a). That is, it is preferable for the alkenyl group-containing organopolysiloxane in the silicone composition consists of the component (a).

The silicone composition of the present invention can comprise various additives other than those described above. Examples of the additive include a dispersant, a flame retardant, a plasticizer, an antioxidant and a colorant. In the two-part curing type silicone composition, each additive may be comprised in either the first agent or the second agent, or both. The additive to be used may be one or two or more selected appropriately from these additives.

<Ratio (H/Vi)>

The silicone composition of the present invention has a ratio (H/Vi) of the number of Si-H to the number of alkenyl groups in the silicone composition in the range of 0.5 or more and 1.5 or less. If the ratio (H/Vi) in the silicone composition is less than 0.5, the curability of the silicone composition decreases, making it difficult to properly cure the silicone. If the ratio (H/Vi) is more than 1.5, the curing may proceed too much, increasing the hardness of the cured product obtained after curing the silicone composition and decreasing the flexibility and elongation of the cured product. If the ratio (H/Vi) is outside the above range, the long-term reliability may be impaired, so that if the product is used for a long period of time in a high-temperature environment after curing, the hardness may increase, causing the product to be detached from a heat-generating element or heat-dissipating element and thereby resulting in an increase in thermal resistance value.

The ratio (H/Vi) is preferably 0.55 or more and 1.3 or less, more preferably 0.65 or more and 1.2 or less, and even more preferably 0.75 or more and 1.1 or less, from the viewpoint of ensuring the flexibility while suppressing an increase in hardness when used in a high-temperature environment, thereby improving the long-term reliability.

The number of alkenyl groups in the ratio (H/Vi) refers to the total number of alkenyl groups in all components in the silicone composition. The number of alkenyl groups in each component can be calculated from the amount of functional groups (mmol/g) in the component (b1) and the content of each component. The same applies to the number of Si-H.

<SiH ratio (b1/b2)>

In the silicone composition of the present invention, the ratio (SiH ratio (b1/b2)) of the number of Si-H in the component (b1) to the number of Si-H in the component (b2) is preferably 0.01 or more and 20 or less. By adjusting the SiH ratio (b1/b2) to fall within the above range, the flexibility, elongation, and long-term reliability after curing the silicone composition can be easily ensured. The SiH ratio (b1/b2) is more preferably 0.1 or more and 15 or less, even more preferably 0.3 or more and 7 or less, and further even more preferably 0.45 or more and 2.5 or less.

The number of Si-H in the SiH ratio (b1/b2) is the total of the number of Si-H in each component in the silicone composition. For example, the number of Si-H in the component (b1) can be calculated from the amount of functional groups (mmol/g) in the component (b1) and the content of the component (b1).

<Type E hardness>

The silicone composition of the present invention preferably has a type E hardness of less than 70 for a cured product obtained by curing the silicone composition. When the type E hardness is less than 70, the cured product obtained from the silicone composition is flexible. Therefore, the obtained cured product is prevented from being detached from a heat-dissipating element or heat-generating element, resulting in a high thermal resistance and a high stress on the surrounding electronic components. The type E hardness of the cured product obtained by curing the silicone composition is more preferably less than 60 and even more preferably less than 50.

In addition, the type E hardness of the cured product obtained by curing the silicone composition is preferably 10 or more. When the type E hardness is a certain value or more, for example, the weight of a member installed on top of the cured product can be sufficiently supported, and the cured product can be prevented from being compressed in the thickness direction during use.

The type E hardness may be measured for the cured product obtained by curing the silicone composition by the method described in the Examples.

<One-part curing type>

The silicone composition of the present invention may be either a one-part curing type composition or a two-part curing type composition. The silicone composition can be cured by heating or the like as necessary to produce a cured product.

The one-part curing type silicone composition of the present invention can be prepared by mixing all the components constituting the silicone composition to produce a resin composition. In this case, the order of blending the components constituting the silicone composition is not particularly limited. However, when the (c) thermally conductive filler is to be surface-treated with the component (e-1) or the component (f) (that is, an organosilicon compound having a hydrolyzable silyl group at the molecular chain end), it is preferred that the component (e-1) or the component (f) is mixed with the (c) thermally conductive filler to allow the component (e-1) or the component (f) to adhere to or react with the surface of the (c) thermally conductive filler, and then further mixed with the other component to prepare a one-part curing type silicone composition.

<Two-part curing type>

The two-part curing type silicone composition is constituted by a combination of a first agent and a second agent. The two-part curing type silicone composition can be obtained by mixing the first agent and the second agent.

In the two-part curing type silicone composition, the mass ratio of the second agent to the first agent (the second agent/the first agent) is preferably 1 or a value close to 1, and is preferably 0.8 or more and 1.2 or less, more preferably 0.9 or more and 1.1 or less, and even more preferably 0.95 or more and 1.05 or less. When the mass ratio of the second agent to the first agent is such a value of 1 or close to 1, the silicone composition is easily prepared.

It is preferred that the first agent and the second agent are each stored in separate containers, and are taken out of the containers and mixed immediately before use. The container is not particularly limited, but it may be a syringe or the like. By using a syringe, the first agent and the second agent dispensed from each syringe can be easily mixed. As described above, the first agent and the second agent can be easily mixed at a mass ratio of 1 or a mass ratio close to 1. It is preferred that the first agent and the second agent are flowable at room temperature (23°C). When the first agent and the second agent are flowable at room temperature, the handleability is enhanced.

When preparing a two-part curing type silicone composition, a first agent and a second agent are prepared separately. Specifically, it is preferred that all the components constituting each of the first agent and the second agent are mixed to prepare each of the first agent and the second agent, separately. In this case, the order of blending the components constituting each of the first agent or the second agent is not particularly limited. However, when the (c)

thermally conductive filler is to be surface-treated, it is preferred that the component (e-1) or the component (f) is allowed to adhere to or react with the surface of the (c) thermally conductive filler as in the case of the one-part curing type silicone composition, and then further mixed with the other component to prepare each of the first agent and the second agent separately.

In the two-part curing type silicone composition, it is preferred that the first agent and the second agent are each prepared so that the reaction does not substantially proceed before they are mixed.

Specifically, in the two-part curing type silicone composition, the first agent comprises an organopolysiloxane having an alkenyl group (alkenyl group-containing organopolysiloxane) and the (d) curing catalyst, but comprises no organohydrogenpolysiloxane. The second agent comprises an organohydrogenpolysiloxane, but does not comprise the (d) curing catalyst. More specifically, the first agent comprises the components (a) and (d), but does not comprise the components (b1) and (b2). The second agent comprises the components (b1) and (b2), but does not comprise the component (d).

Since the first agent having the above configuration comprises the (d) curing catalyst, which promotes the addition reaction but comprises no organohydrogenpolysiloxane, the addition reaction can be prevented from proceeding before the first agent is mixed with the second agent. On the other hand, since the second agent comprises the organohydrogenpolysiloxane but does not comprise the (d) curing catalyst that promotes the addition reaction, the addition reaction can be prevented from proceeding before the second agent is mixed with the first agent.

In the case of the two-part curing type, (c) the thermally conductive filler may be blended into either the first agent or the second agent, or both, but it is preferably blended into both.

Therefore, it is preferable that the first agent comprises the components (a), (c) and (d) but does not comprise the components (b1) and (b2), and that the second agent comprises the components (b1), (b2) and (c) but does not comprise the component (d).

By including the (c) thermally conductive filler in both the first agent and the second agent, the specific gravity of the first agent and the second agent can be made approximately the same, and the miscibility of the first agent and the second agent can be thereby improved. Furthermore, the mass ratio between the first agent and the second agent is easily adjusted to 1 or close to 1.

The alkenyl group-containing organopolysiloxane constituting the silicone composition may be entirely comprised in the first agent, but it is preferable that a portion thereof is comprised in the first agent and the remainder in the second agent. More specifically, the component (a) in the silicone composition may be entirely comprised in the first agent, but it is preferable that a portion thereof is comprised in the first agent and the remainder in the second agent.

By dividing the alkenyl group-containing organopolysiloxane between the first agent and the second agent in this way, the viscosity of each of the first agent and the second agent is easily adjusted within a desired range, and the mass ratio between the first agent and the second agent is easily adjusted to 1 or close to 1. Since the second agent also comprises an organohydrogenpolysiloxane but does not comprise the (d) curing catalyst, the addition reaction can be substantially prevented from proceeding during storage or the like, even when it comprises an alkenyl group-containing organopolysiloxane.

The organohydrogenpolysiloxane constituting the silicone composition is entirely comprised in the second agent, but not in the first agent. Therefore, the components (b1) and (b2) are entirely comprised in the second agent.

The silicone composition preferably comprises the component (e). It is preferred that at least one of the first agent and the second agent comprises the component (e), and it is more preferred that both the first agent and the second agent comprises the component (e). When both the first agent and the second agent comprise the component (e), the viscosity of the first agent and the second agent can be adjusted by the component (e) so that both the first agent and the second agent have a relatively low viscosity.

When the component (e) comprises the component (e-1), it is more effective and preferable to include the component (e-1) in the agent (the first agent, second agent, or both) comprising the (c) thermally conductive filler. That is, each of the first agent and the second agent preferably comprises both the (c) thermally conductive filler and the component (e), but in particular, each of the first agent and the second agent more preferably comprises the (c) thermally conductive filler and the component (e-1).

The silicone composition may comprise the component (f) (a silane coupling agent), but it is preferred that at least one of the first agent and the second agent comprises the component (f). It is more effective and more preferable that the agent (the first agent, second agent, or both) comprising the (c) thermally conductive filler comprises the component (f). That is, when the silicone composition comprises the component (f) (a silane coupling agent), it is preferable that each of the first agent and the second agent comprises both the (c) thermally conductive filler and the silane coupling agent.

The silicone compositions may comprise the component (g) (a curing inhibitor). Either one of the first agent and the second agent may comprise the component (g), but both may comprise the component (g). However, when the second agent comprises both an organohydrogenpolysiloxane (for example, the components (b1) and (b2)) and an alkenyl group-containing organopolysiloxane (for example, the component (a)), the second agent preferably comprises the curing inhibitor. Even when the second agent comprises both an organohydrogenpolysiloxane and an alkenyl group-containing

organopolysiloxane, the reactions therebetween can be prevented from proceeding in the second agent by further including (g) a reaction controlling agent in the second agent.

[Heat-dissipating member]

The silicone composition of the present invention can be used as a raw material to produce a heat-dissipating member formed by the silicone composition. For example, the silicone composition can be formed into a predetermined shape and then appropriately cured by heating or the like to produce a heat-dissipating member shaped into a predetermined shape. The heat-dissipating member is interposed between a heat-generating element and a heat-dissipating element, and transfers the heat generated by the heat-generating element to the heat-dissipating element by thermal conduction to dissipate the heat from the heat-dissipating element. Examples of the heat-generating element include various electronic components used inside electronic devices such as a CPU, a power amplifier and a power supply. Examples of the heat-dissipating element include a heat sink, a heat pump and a metal housing of electronic devices.

The heat-dissipating member can be used inside an electronic device to provide an electronic device comprising an electronic component and a heat-dissipating member disposed on the electronic component. Specifically, the heat-dissipating member can be disposed between an electronic component such as a semiconductor device and a heat-dissipating element such as a heat sink to effectively dissipate the heat generated from the electronic component.

Examples

Hereinafter, the present invention will be clearly described with reference to the specific examples and the comparative examples of the present invention. However, the present invention is not limited to the following Examples.

The measurement method and evaluation method for each of physical properties are as follows.

[Viscosity]

The viscosity was measured at 23°C with a Brookfield Type B viscometer. The measurement was carried out with "HB DVE" manufactured by EKO INSTRUMENTS CO., LTD., as a measuring apparatus. The rotation speed was set to 10 rpm, and the value measured 3 minutes after the start of rotation was taken as the viscosity. In the Brookfield B-type viscometer, the spindle was properly selected so that the torque was 10 to 80%.

[Coefficient of Thermal Conductivity]

The coefficient of thermal conductivity was measured at 23°C for the silicone composition before curing, in accordance with ASTM D5470. The measurement was carried out with "T3Ster DynTIM Tester" available from Mentor, a Siemens Business, as measuring apparatus, and the evaluation was carried out according to the following criteria.

OK: 3 W/m·K or more
NG: less than 3 W/m·K

[Hardness measurement]

The hardness was measured at 25°C with an automatic hardness measuring apparatus, "GX-02E", Type E manufactured by TECLOCK Co., Ltd. The cured products obtained in each Example and Comparative Example were subjected to the measurement of the initial hardness and was evaluated according to the following criteria.

A: Hardness of 10 or more and less than 50
B: Hardness of 50 or more and less than 70
C: Hardness of 70 or more

[Long-term reliability (long-term thermal resistance value)]

Each of the silicone compositions obtained in each Example and Comparative Example was applied onto a copper block having 25.4 mm × 25.4 mm in size, sandwiched between this block and another copper block, and a 1 mm spacer was used to ensure that the thickness was uniform. The silicone composition was allowed to stand at room temperature (23°C) for 24 hours for curing. The thermal resistance value of the silicone composition after curing was measured and was taken as the initial thermal resistance value. Thereafter, it was heated in an oven at 150°C for 250

hours, the thermal resistance value thereof was measured, and the rate of change in the thermal resistance value was calculated according to the following equation. The rate of change in the thermal resistance value was evaluated according to the evaluation criteria described below.

Rate of change in thermal resistance value (%) = [thermal resistance value after heating/initial thermal resistance value] × 100

The thermal resistance value was measured as follows. A heater was installed on one side of the copper block, and a heat sink with a fan was installed on another side thereof. The heater was used to generate heat, and when the temperature reached a constant temperature, the temperature on one side (T1) and the temperature on another side (T2) and the amount of heat generated (Q) were measured, and the thermal resistance value was calculated according to the following equation.

$$\text{Thermal resistance value} = (T1 - T2) / Q$$

In addition, the long-term reliability was evaluated based on the following criteria.

A: 100% or more and less than 125%
B: 125% or more and less than 150%
C: 150% or more

[Elongation]

The cured product of the silicone composition obtained in each of Examples and Comparative Examples was sampled in the form of a strip having a width of 10 mm and a length of 100 mm to prepare a test specimen. The test specimen was subjected to measurement of tensile elongation at break at 23°C with "Universal Tensile Testing Instrument RTC-1310A, manufactured by ORIENTEC CO., LTD." as a tensile tester.

Elongation was also evaluated based on the following criteria.

A: 125% or more
B: 110% or more and less than 125%
C: Less than 110%

The components used in each Example and Comparative Example are as follows. The vinyl group content of the alkenyl group-containing organopolysiloxane and the SiH content of the organohydrogenpolysiloxane are as shown in the column of "amount of functional groups" in Table 1.

[Alkenyl group-containing organopolysiloxane]

<Component (a)>

A-1: Organopolysiloxane, having vinyl groups only at the two molecular chain ends, represented by formula (A): the number of vinyl groups in one molecule = 2

[Organohydrogenpolysiloxane]

<Component (b-1)>

B-1: Organohydrogenpolysiloxane, having Si-H at both the two molecular chain ends and the molecular-chain side chain, represented by formula (B1): the number of Si-H in one molecule = 6 (2 at the ends, 4 at the side chains)
B-2: Organohydrogenpolysiloxane, having Si-H at both the two molecular chain ends and the molecular-chain side chain, represented by formula (B1): the number of Si-H in one molecule = 12 (2 at the ends, 10 at the side chains)
B-3: Organohydrogenpolysiloxane, having Si-H at both the two molecular chain ends and the molecular-chain side chain, represented by formula (B1): the number of Si-H in one molecule = 17 (2 at the ends, 15 at the side chains)
B-4: Organohydrogenpolysiloxane, having Si-H at both the two molecular chain ends and the molecular-chain side

chain, represented by formula (B1): the number of Si-H in one molecule = 4 (2 at the ends, 2 at the side chains)

<Component (b2)>

B-5: Organohydrogenpolysiloxane, having Si-H only at the two molecular chain ends, represented by formula (B2): the number of Si-H in one molecule = 2 (2 at the ends)

<Component (b3)>

B-6: Organohydrogenpolysiloxane having Si-H only at the molecular-chain side chain: the number of Si-H in one molecule = 10 (10 at the side chains)

[Thermally conductive filler]

C-1: Alumina 1 (average particle diameter of primary particles: 3 μm)
C-2: Alumina 2 (average particle diameter of primary particles: 0.5 μm)
C-3: Aluminum nitride (average particle diameter of primary particles: 10 μm)
C-4: Diamond (average particle diameter of primary particles: 12 μm)

[Curing catalyst]

D-1: Platinum-based catalyst

[Addition reactive group-containing organopolysiloxane]

E-1(1): Compound represented by formula (1-1) wherein n is 10 to 11.
E-1 (2): Compound represented by formula (2-1) wherein m is 30.

[Curing inhibitor]

G-1: Curing inhibitor, 3,5-dimethyl-1-hexyn-3-ol

[Examples 1 to 11 and Comparative Examples 1 to 4]

Each silicone composition was prepared according to each of the formulations shown in Table 1. The obtained silicone composition was used to evaluate the coefficient of thermal conductivity. The obtained silicone composition was cured at room temperature for 24 hours to obtain a cured product. The obtained cured product was subjected to evaluation of the initial hardness and elongation. The obtained silicone composition was also used to evaluate the long-term reliability. The evaluation results are shown in Table 1.

[Table 1]

| | | | | Viscosity (mPa·s) | Amount of functional groups (mmol/g) | Example | | | | | | | | | | | Comparative Example | | | |
|---|---|---|---|---|---|---|---|---|---|---|---|---|---|---|---|---|---|---|---|---|
| | | | | | | 1 | 2 | 3 | 4 | 5 | 6 | 7 | 8 | 9 | 10 | 11 | 1 | 2 | 3 | 4 |
| Formulation (parts by mass) | Alkyl group-containing organopolysiloxane | A-1 | Vinyl at two ends | 100 | 0.4 | 51.0 | 53.7 | 51.4 | 53.5 | 57.1 | 59.6 | 45.3 | 51.1 | 50.8 | 50.1 | 51.7 | 65.6 | 75.9 | 76.9 | 45.9 |
| | Organohydrogenpolysiloxane | B-1 | SiH at both two ends and side chains (at side chains 4) | 110 | 0.95 | 8.5 | | | | 20.8 | 6.4 | 9.7 | 8.5 | 8.5 | 8.4 | 8.6 | | | | |
| | | B-2 | SiH at both two ends and side chains (at side chains 10) | 120 | 2.21 | | 4.9 | | | | | | | | | | | | | |
| | | B-3 | SiH at both two ends and side chains (at side chains 15) | 110 | 3.05 | | | 2.4 | | | | | | | | | | 9.9 | 2.3 | 5.1 |
| | | B-4 | SiH at both two ends and side chains (at side chains 2) | 95 | 0.61 | | | | 18.9 | | | | | | | | | | | |
| | | B-5 | SiH only at two ends | 100 | 0.4 | 28.3 | 26.8 | 32.1 | 15.7 | 7.8 | 21.3 | 32.4 | 28.4 | 28.2 | 27.9 | 28.7 | 19.7 | | 11.3 | 38.3 |
| | | B-6 | SiH at side chains (at side chains 10) | 105 | 1.93 | | | | | | | | | | | | 9.8 | | | |
| | Thermally conductive filler | C-1 | Alumina 1(average particle diameter 3μm) | | | 1416 | 1610 | 1499 | 1541 | 1610 | 1468 | 1456 | | | 975 | 1437 | 1705 | 1617 | 1131 | 1276 |
| | | C-2 | Alumina 2(average particle diameter 0.5μm) | | | | | | | | | | | | 306 | | | | | |
| | | C-3 | AlN(average particle diameter 10μm) | | | | | | | | | | 1136 | | | | | | | |
| | | C-4 | Diamond (average particle diameter 12μm) | | | | | | | | | | | 1073 | | | | | | |
| | Organopolysiloxane containing no addition reactive group | E-1(1) | Formula (1-1) | | | 12.2 | 14.6 | 14.1 | 11.9 | 14.3 | 12.8 | 12.6 | 11.9 | 12.4 | 13.6 | | 14.8 | 14.2 | 9.5 | 10.7 |
| | | E-1(2) | Formula (1-2) | | | | | | | | | | | | | 10.9 | | | | |
| | Platinum-based catalyst | D-1 | | | | 10 ppm | 10 ppm | 10 ppm | 10 ppm | 10 ppm | 10 ppm | 10 ppm | 10 ppm | 10 ppm | 10 ppm | 10 ppm | 10 ppm | 10 ppm | 10 ppm | 10 ppm |
| | Curing inhibitor | G-1 | | | | 200 ppm | 200 ppm | 200 ppm | 200 ppm | 200 ppm | 200 ppm | 200 ppm | 200 ppm | 200 ppm | 200 ppm | 200 ppm | 200 ppm | 200 ppm | 200 ppm | 200 ppm |
| Functional group Ratio | H/Vi | | | | | 0.95 | 1.00 | 0.97 | 0.83 | 1.00 | 0.61 | 1.22 | 0.95 | 0.95 | 0.95 | 0.95 | 1.02 | 0.99 | 0.37 | 1.68 |
| | b1/b2 ratio | | | | | 0.71 | 1.00 | 0.56 | 1.83 | 6.33 | 0.71 | 0.71 | 0.71 | 0.71 | 0.71 | 0.71 | 2.41 | - | 1.53 | 1.02 |
| Physical properties | Coefficient of thermal conductivity | | | | | ○ | ○ | ○ | ○ | ○ | ○ | ○ | ○ | ○ | ○ | ○ | ○ | ○ | ○ | ○ |
| | Hardness | | | | | A | A | B | A | B | A | B | A | A | A | A | B | C | × | C |
| | Long-term thermal resistance value | | | | | A | A | B | A | A | B | B | A | A | A | A | C | B | - | C |
| | Elongation | | | | | A | A | B | A | B | A | B | A | A | A | A | B | C | - | C |

Each of the silicone compositions of Examples 1 to 11 as described above comprised both the components (b1) and (b2), and the ratio of the number of SiH to the number of alkenyl groups (H/Vi) was within a predetermined range. Therefore, despite of its high coefficient of thermal conductivity and good thermal conductivity, it was low in initial hardness and flexible, and good in elongation. Further, even after heating at 150°C for a long period of time after curing, an increase in the thermal resistance value was small and the long-term reliability was good.

In contrast, since each of the silicone compositions of Comparative Examples 1 and 2 did not comprise either one of the components (b1) and (b2), the elongation could not be improved and the long-term reliability was also low. In Comparative Example 3, due to too low ratio (H/Vi), curing was poor. In Comparative Example 4, due to too high ratio (H/Vi), curing proceeded too much, and the hardness thereby increased and the long-term reliability also deteriorated.

## Claims

1. A silicone composition comprising:

   (a) an organopolysiloxane having at least two alkenyl groups in one molecule;
   (b1) an organohydrogenpolysiloxane having hydrogen atoms directly bonded to silicon atoms at both two molecular chain ends and molecular-chain side chain;
   (b2) an organohydrogenpolysiloxane having hydrogen atoms directly bonded to silicon atoms only at two molecular chain ends;
   (c) a thermally conductive filler; and
   (d) a curing catalyst;
   a ratio (H/Vi) of the number of hydrogen atoms being directly bonded to silicon atoms to the number of alkenyl groups is in the range of 0.5 or more and 1.5 or less.

2. The silicone composition according to claim 1, wherein a viscosity at 23°C of the component (a) is 20 mPa·s or more and 100,000 mPa·s or less.

3. The silicone composition according to claim 1 or 2, wherein a content of the (c) thermally conductive filler is 1,000 parts by mass or more and 4,000 parts by mass or less relative to 100 parts by mass of the organopolysiloxane in the silicone composition.

4. The silicone composition according to claim 1 or 2, wherein a content of the (d) curing catalyst is 0.1 ppm by mass or

more and 500 ppm by mass or less.

**5.** The silicone composition according to claim 1 or 2, further comprising (g) a curing inhibitor.

**6.** The silicone composition according to claim 1 or 2, comprising an organosilicon compound having a hydrolyzable silyl group at the molecular chain end.

**7.** The silicone composition according to claim 1 or 2, wherein in the component (b1), the molecular-chain side chains have 4 to 15 hydrogen atoms.

**8.** The silicone composition according to claim 1 or 2, wherein a ratio (b1/b2) of the number of hydrogen atoms in the component (b1) to the number of hydrogen atoms in the component (b2) is 0.01 to 20.

**9.** The silicone composition according to claim 1 or 2, wherein the (c) thermally conductive filler is at least one selected from the group consisting of an oxide, a nitride, a carbide, a carbon-based material and a metal hydroxide.

**10.** The silicone composition according to claim 1 or 2, wherein the (c) thermally conductive filler is at least one selected from the group consisting of alumina, diamond and aluminum nitride.

**11.** The silicone composition according to claim 1 or 2, wherein primary particles of the (c) thermally conductive filler have an average particle diameter of 0.1 μm or more.

**12.** The silicone composition according to claim 1 or 2, wherein the (c) thermally conductive filler comprises two or more types of particles different in average particle diameters of primary particles.

**13.** The silicone composition according to claim 1 or 2, further comprising (e) an organopolysiloxane having no addition reactive group.

**14.** The silicone composition according to claim 13, comprising, as the component (e), at least one compound selected from the group consisting of a compound represented by the following formula (1) and a compound represented by the following formula (2):

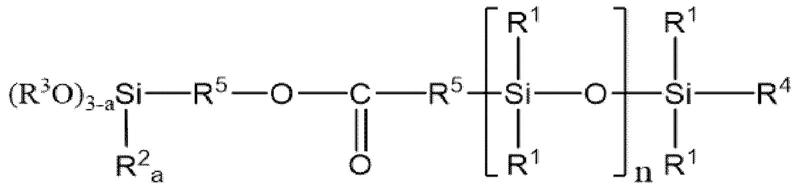 (1)

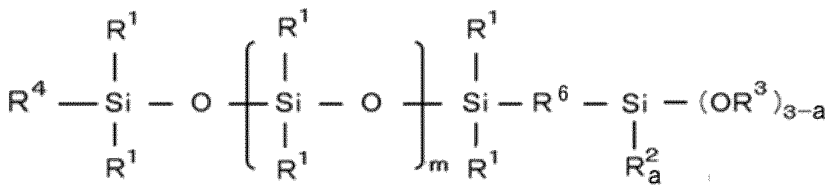 (2)

wherein:

in each of the formulas (1) and (2), each $R^1$ is independently any one of an alkyl group having 1 to 20 carbon atoms, a halogenated alkyl group having 1 to 20 carbon atoms, an aryl group having 6 to 20 carbon atoms and an aralkyl group having 7 to 20 carbon atoms, and the multiple $R^1$s in each formula may be each the same or different; each $R^2$ is independently an alkyl group having 1 to 4 carbon atoms, and when multiple $R^2$s are present in each formula, the multiple $R^2$s may be each the same or different; each $R^3$ is independently any one of an alkyl group having 1 to 4 carbon atoms, an alkoxyalkyl group having 2 to 4 carbon atoms and an acyl group having 2 to 4 carbon atoms, and when multiple $R^3$s are present in each formula, the multiple $R^3$s may be each the same or different; and each $R^4$ is independently an alkyl group having 1 to 8 carbon atoms;
in the formula (1), each $R^5$ is independently a divalent hydrocarbon group having 2 to 20 carbon atoms, and the

multiple $R^5$s may be each the same or different;
in the formula (2), $R^6$ is an oxygen atom or a divalent hydrocarbon group having 2 to 20 carbon atoms;
in each of the formulas (1) and (2), a is an integer from 0 to 2;
in the formula (1), n is an integer from 4 to 150; and
in the formula (2), m is an integer from 15 to 315.

**15.** The silicone composition according to claim 1 or 2, wherein a cured product obtained by curing the silicone composition has a type E hardness of less than 70.

**16.** A heat-dissipating member formed from the silicone composition according to claim 1 or 2.

**17.** An electronic device comprising an electronic component and the heat-dissipating member according to claim 16 disposed on the electronic component.

**INTERNATIONAL SEARCH REPORT**

International application No. **PCT/JP2023/022389**

**A. CLASSIFICATION OF SUBJECT MATTER**

***C08L 83/07***(2006.01)i; ***C08K 3/013***(2018.01)i; ***C08L 83/05***(2006.01)i; ***C08L 83/06***(2006.01)i; ***H01L 23/373***(2006.01)i
FI: C08L83/07; C08K3/013; C08L83/05; C08L83/06; H01L23/36 M

According to International Patent Classification (IPC) or to both national classification and IPC

**B. FIELDS SEARCHED**

Minimum documentation searched (classification system followed by classification symbols)

C08L83/07; C08K3/013; C08L83/05; C08L83/06; H01L23/373

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | WO 2015/178140 A1 (SHIN-ETSU CHEMICAL CO., LTD.) 26 November 2015 (2015-11-26)<br>claims, paragraph [0035], example 5 | 1-2, 4-9, 13, 15<br>3, 10-12, 14, 16-17 |
| A | JP 2012-153774 A (SHIN-ETSU CHEMICAL CO., LTD.) 16 August 2012 (2012-08-16) | 1-17 |
| A | JP 11-124503 A (SHIN-ETSU CHEMICAL CO., LTD.) 11 May 1999 (1999-05-11) | 1-17 |
| A | JP 2011-46826 A (SHIN-ETSU CHEMICAL CO., LTD.) 10 March 2011 (2011-03-10) | 1-17 |
| A | WO 2017/098961 A1 (SHIN-ETSU CHEMICAL CO., LTD.) 15 June 2017 (2017-06-15) | 1-17 |
| A | WO 2020/145249 A1 (SHIN-ETSU CHEMICAL CO., LTD.) 16 July 2020 (2020-07-16) | 1-17 |
| A | JP 2000-204259 A (SHIN-ETSU CHEMICAL CO., LTD.) 25 July 2000 (2000-07-25) | 1-17 |
| A | JP 2018-123310 A (MOMENTIVE PERFORMANCE MATERIALS JAPAN LLC) 09 August 2018 (2018-08-09) | 1-17 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 August 2023** | **22 August 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2023/022389**

**C. DOCUMENTS CONSIDERED TO BE RELEVANT**

| Category* | Citation of document, with indication, where appropriate, of the relevant passages | Relevant to claim No. |
|---|---|---|
| A | WO 2009/060616 A1 (MOMENTIVE PERFORMANCE MATERIALS JAPAN LLC) 14 May 2009 (2009-05-14) | 1-17 |
| A | CN 110499032 A (JIANGXI BLUESTAR XINGHUO ORGANIC SILICONE CO., LTD.) 26 November 2019 (2019-11-26) | 1-17 |

Form PCT/ISA/210 (second sheet) (January 2015)

**INTERNATIONAL SEARCH REPORT**
**Information on patent family members**

International application No.
**PCT/JP2023/022389**

| Patent document cited in search report | Publication date (day/month/year) | Patent family member(s) | Publication date (day/month/year) |
|---|---|---|---|
| WO 2015/178140 A1 | 26 November 2015 | US 2017/0081515 A1 claims, paragraph [0047], example 5 | |
| | | EP 3147330 A1 | |
| | | KR 10-2017-0010313 A | |
| | | CN 106414611 A | |
| | | TW 201609979 A | |
| JP 2012-153774 A | 16 August 2012 | CN 102618036 A | |
| | | KR 10-2012-0086249 A | |
| JP 11-124503 A | 11 May 1999 | JP 2006-77262 A | |
| | | US 5900438 A | |
| JP 2011-46826 A | 10 March 2011 | (Family: none) | |
| WO 2017/098961 A1 | 15 June 2017 | JP 2017-105930 A | |
| | | US 2018/0346722 A1 | |
| | | EP 3388488 A1 | |
| | | CN 108368345 A | |
| | | KR 10-2018-0093003 A | |
| | | TW 201726813 A | |
| | | PL 3388488 T | |
| WO 2020/145249 A1 | 16 July 2020 | JP 2020-111670 A | |
| | | US 2022/0064449 A1 | |
| | | EP 3910028 A1 | |
| | | CN 113272387 A | |
| | | KR 10-2021-0113302 A | |
| | | TW 202039694 A | |
| JP 2000-204259 A | 25 July 2000 | (Family: none) | |
| JP 2018-123310 A | 09 August 2018 | US 2021/0130615 A1 | |
| | | WO 2018/139506 A1 | |
| | | EP 3575365 A1 | |
| | | TW 201833296 A | |
| | | CN 110234711 A | |
| | | KR 10-2019-0104075 A | |
| WO 2009/060616 A1 | 14 May 2009 | JP 2009-114403 A | |
| | | EP 2221343 A1 | |
| | | CN 101855300 A | |
| | | KR 10-2010-0085042 A | |
| | | CN 105295381 A | |
| CN 110499032 A | 26 November 2019 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6149831 B
- JP 6079792 B
- JP 6388072 B